Europäisches Patentamt

European Patent Office

Office européen des brevets

(19)

(11) **EP 0 813 297 B1**

(12) **FASCICULE DE BREVET EUROPEEN**

(45) Date de publication et mention
de la délivrance du brevet:
**27.11.2002 Bulletin 2002/48**

(51) Int Cl.⁷: **H03G 7/00**

(21) Numéro de dépôt: **97201705.7**

(22) Date de dépôt: **05.06.1997**

(54) **Dispositif d'amplification à gain commandé numeériquement et caméra mettant en oeuvre un tel dispositif**

Verstärker mit digital gesteuerter Verstärkung und Kamera mit einem solchen Verstärker

Amplifier with digital gain control and camera using the same

(84) Etats contractants désignés:
**DE FR GB IT**

(30) Priorité: **14.06.1996 FR 9607447**

(43) Date de publication de la demande:
**17.12.1997 Bulletin 1997/51**

(73) Titulaire: **Koninklijke Philips Electronics N.V.
5621 BA Eindhoven (NL)**

(72) Inventeurs:
 • **Dartheney, Frédéric
  75008 Paris (FR)**
 • **Morisson, Richard
  75008 Paris (FR)**
 • **Raoulx, Denis
  75008 Paris (FR)**

(74) Mandataire: **Charpail, François et al
Société Civile S.P.I.D.
156, Boulevard Haussmann
75008 Paris (FR)**

(56) Documents cités:
**US-A- 5 216 384**

 • **RADIO FERNSEHEN ELEKTRONIK, vol. 42, no. 4, avril 1993, BERLIN DE, page 63 XP000392514 H. K.: "Breitbandverstärker mit digital gesteuerter Verstärkung"**
 • **INTERNATIONAL SYMPOSIUM ON CIRCUITS AND SYSTEMS. (ISCAS), LINEAR CIRCUITS AND SYSTEMS (LCS), ANALOG SIGNAL PROCESSING (ASP) LONDON, MAY 30 - JUNE 2, 1994, vol. 5, 30 mai 1994, INSTITUTE OF ELECTRICAL AND ELECTRONICS ENGINEERS, pages 377-380, XP000592861 GUILHERME J ET AL: "DIGITALLY-CONTROLLED ANALOGUE SIGNAL PROCESSING AND CONVERSION TECHNIQUES EMPLOYING A LOGARITHMIC BUILDING BLOCK"**

**Description**

La présente invention telle que définie par les revendications concerne un dispositif d'amplification à gain commandé, présentant une entrée analogique destinée à recevoir une tension dite tension analogique d'entrée, une entrée numérique destinée à recevoir un mot de M bits, dit mot de commande, servant à commander le gain du dispositif, et une sortie analogique destinée à délivrer une tension dite tension analogique de sortie.

Dans un certain nombre d'applications, on souhaite pouvoir faire varier le gain en décibels d'un tel dispositif de manière linéaire en fonction de la valeur numérique du mot de commande. La plupart des dispositifs réalisant une telle fonction soumettent le mot de commande numérique à une conversion visant à le transformer en une tension de commande analogique dont la variation en fonction de la valeur numérique du mot de commande, combinée à une fonction de transfert propre au dispositif d'amplification, provoque une variation quasi-linéaire du gain en décibels du dispositif. Ce système de conversion s'avère souvent complexe et conduit alors à des circuits de grande taille. De plus, l'erreur produite lors de la conversion du mot numérique se trouve multipliée lors de l'amplification proprement dite. Enfin, de part sa nature analogique, la tension de commande présente un certain bruit qui se trouve également multiplié lors de l'amplification. Par conséquent, plus le gain du dispositif d'amplification est grand, plus l'erreur par rapport au gain linéaire nominal est importante.

Le document "Radio Fernsehen Elektronik" d'Avril 1993 présente par ailleurs un dispositif d'amplification autorisant une sélection d'une valeur de gain parmi quatre, mais les variations de gain ainsi obtenues sont discontinues, et par conséquent non linéaires.

La présente invention a pour but de remédier à ces inconvénients en proposant un amplificateur dans lequel le mot de commande agit en grande partie directement sur le résultat de l'amplification de la tension analogique d'entrée.

En effet, un dispositif d'amplification selon la présente invention est caractérisé en ce qu'il comprend :

- un étage dit d'amplification, présentant une entrée formant l'entrée analogique du dispositif et K sorties, contenant K amplificateurs, chaque amplificateur présentant une entrée reliée à l'entrée de l'étage et une sortie formant l'une des K sorties de l'étage, les amplificateurs ayant des gains en décibels différents les uns des autres, le gain en décibels de chaque amplificateur étant un multiple d'une valeur appelée G0,
- un étage dit de sélection présentant K entrées logiques, muni de moyens pour activer une seule des K sorties de l'étage d'amplification et pour désactiver les autres, en fonction des signaux reçus sur les K entrées logiques, matérialisés par les K bits de poids le plus fort du mot de commande,
- un amplificateur à gain commandé, présentant une entrée analogique recevant celle des K sorties de l'étage d'amplification qui a été activée par l'étage de sélection, une entrée numérique recevant un mot numérique constitué des N bits de poids le plus faible du mot de commande, et une sortie analogique constituant la sortie analogique du dispositif, amplificateur dont le gain varie en fonction de la valeur du mot reçu sur son entrée numérique.

Dans un tel dispositif, une grande part de l'amplification a lieu directement dans l'étage d'amplification et indépendamment du mot de commande. L'étage de sélection permet de sélectionner directement celle des sorties de l'étage d'amplification qui doit être activée. Le gain en décibels de l'étage d'amplification évolue de manière parfaitement linéaire en fonction des (M-N) bits de poids le plus fort du mot de commande. Les N bits de poids le plus faible du mot de commande permettent d'affiner la valeur du gain total du dispositif. Si l'amplificateur à gain commandé présente un gain en décibels qui n'évolue pas linéairement en fonction de la valeur du mot reçu sur son entrée numérique, cette erreur sera limitée par le faible gain maximum que cet amplificateur fournira. Il introduira donc dans le gain total du dispositif une erreur minime par rapport au gain linéaire nominal. De plus, l'écart par rapport à la linéarité étant uniquement dû à l'amplificateur à gain commandé, il sera complètement indépendant de la valeur totale du gain et n'augmentera donc pas lorsque celui-ci augmentera. Au contraire, l'écart relatif diminuera.

Un mode de réalisation de l'invention présente un dispositif d'amplification à gain commandé, présentant une entrée analogique destinée à recevoir une tension dite tension analogique d'entrée, une entrée numérique destinée à recevoir un mot de M bits, dit mot de commande, servant à commander le gain du dispositif, et une sortie analogique destinée à délivrer une tension dite tension analogique de sortie, caractérisé en ce qu'il comprend :

- un étage dit d'amplification, présentant une entrée formant l'entrée analogique du dispositif et K sorties, contenant K amplificateurs, chaque amplificateur présentant une entrée reliée à l'entrée de l'étage et une sortie formant l'une des K sorties de l'étage, les amplificateurs ayant des gains en décibels différents les uns des autres, le gain en décibels de chaque amplificateur étant un multiple d'une valeur appelée G0,
- un étage dit de commutation présentant K entrées analogiques reliées aux K sorties de l'étage d'amplification, une sortie analogique et K entrées logiques, étage comprenant K interrupteurs, commandés chacun par un signal reçu sur une des K entrées logiques, les interrupteurs ayant tous une borne reliée en commun, formant ainsi la sortie analogique de l'étage, les autres bornes des interrupteurs formant les K entrées analogiques de l'étage,

. un amplificateur à gain commandé, présentant une entrée analogique reliée à la sortie analogique de l'étage de commutation, une entrée numérique recevant un mot numérique constitué des N bits de poids le plus faible du mot de commande, et une sortie analogique constituant la sortie analogique du dispositif, amplificateur dont le gain varie en fonction de la valeur du mot reçu sur son entrée numérique.

. un décodeur présentant une entrée numérique de (M-N) bits recevant un mot numérique constitué des (M-N) bits de poids le plus fort du mot de commande, décodeur présentant K sorties logiques reliées aux K entrées logiques de l'étage de commutation, sorties logiques dont une seule est placée dans un état actif, la position de ladite sortie logique étant fonction de la valeur du mot que le décodeur a reçu sur son entrée numérique.

Une variante de l'invention présente un dispositif d'amplification à gain contrôlé tel que décrit ci-dessus, caractérisé en ce que les valeurs des gains en décibels des amplificateurs de l'étage d'amplification sont des multiples successifs de G0, et en ce que le gain en décibels de l'amplificateur à gain commandé varie de zéro à G0.

L'écart séparant les gains en décibels des amplificateurs de l'étage d'amplification est ainsi réduit, ce qui réduit l'erreur introduite par l'amplificateur à gain commandé.

Un mode de réalisation avantageux de l'invention présente un dispositif d'amplification tel que décrit ci-dessus, caractérisé en ce que, considérant les amplificateurs de l'étage d'amplification dans un ordre correspondant à celui des gains croissants, la sortie de l'amplificateur de gain le plus faible est reliée à celui des interrupteurs de l'étage de commutation qui est commandé par la sortie logique commandée par le bit de poids le plus faible reçu sur l'entrée numérique du décodeur, les sorties successives des autres amplificateurs étant respectivement reliées à ceux des interrupteurs de l'étage de commutation qui sont commandés par ordre croissant en fonction de l'augmentation de la valeur du mot de commande.

Une telle disposition facilite la sélection directe par les K sorties du décodeur de celle des sorties de l'étage d'amplification qui doit être activée. La structure du décodeur en est simplifiée.

L'invention concerne également une caméra contenant :

. un dispositif de détection de lumière et de conversion de la lumière en signaux électroniques analogiques,

. un dispositif d'amplification présentant une entrée de signal analogique destinée à recevoir les dits signaux électroniques analogiques, une entrée numérique destinée à recevoir un mot numérique, dit mot de commande, pour contrôler le gain du dispositif d'amplification, et une sortie de signal analogique,

. un convertisseur analogique/numérique présentant une entrée analogique reliée à la sortie du dispositif d'amplification, et une sortie numérique, et

. une unité de traitement numérique dont une entrée est reliée à la sortie du convertisseur analogique/numérique, unité destinée à émettre le mot de commande vers le dispositif d'amplification,

caractérisée en ce que ledit dispositif d'amplification est tel que décrit plus haut.

L'invention sera mieux comprise à l'aide de la description suivante, faite à titre d'exemple et en regard des dessins annexés, dans lesquels :

- la figure 1 est un schéma fonctionnel décrivant partiellement un dispositif d'amplification selon un mode de réalisation de l'invention,

- la figure 2 est une caractéristique représentant l'évolution du gain en décibels d'un dispositif d'amplification suivant l'invention, en fonction de la valeur numérique du mot de commande, et

- la figure 3 est un schéma fonctionnel décrivant partiellement une caméra mettant en ouvre un amplificateur à gain contrôlé selon l'invention.

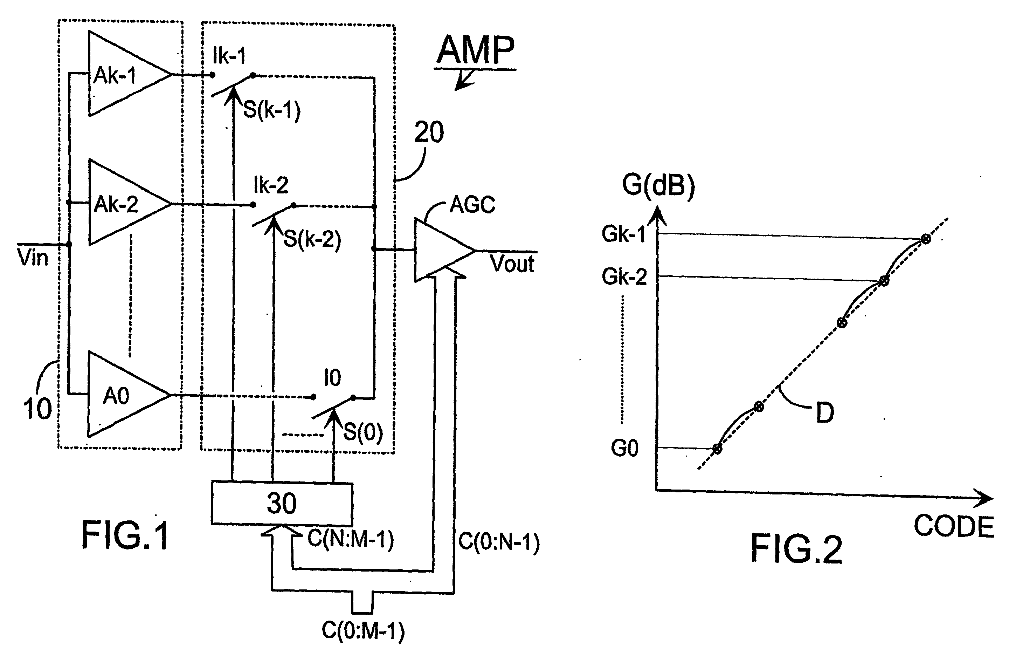

Selon la figure 1, un dispositif d'amplification AMP conforme à l'invention présente une entrée analogique destinée à recevoir une tension dite tension analogique d'entrée Vin, une entrée numérique destinée à recevoir un mot de M bits C(0:M-1), dit mot de commande, servant à commander le gain du dispositif, et une sortie analogique destinée à délivrer une tension dite tension analogique de sortie Vout et comprend :

. un étage 10 dit d'amplification, présentant une entrée formant l'entrée analogique du dispositif et K sorties, contenant K amplificateurs A0,...,Ak-1, chaque amplificateur Ai (pour i=1 à k-1) présentant une entrée reliée à l'entrée de l'étage et une sortie formant l'une des K sorties de l'étage, les amplificateurs A0,...,Ak-1 ayant des gains en décibels différents les uns des autres, les gains en décibels Gi (pour i=0 à k-1) des amplificateurs Ai étant des multiples successifs d'une valeur appelée G0,

. un étage 20 dit de commutation présentant K entrées analogiques reliées aux K sorties de l'étage d'amplification, une sortie analogique et K entrées logiques, étage comprenant K interrupteurs I0,...,Ik-1, commandés chacun par un signal reçu sur une des K entrées logiques, les interrupteurs I0,...,Ik-1 ayant tous une borne reliée en commun, formant ainsi la sortie analogique de l'étage, les autres bornes des interrupteurs I0,...,Ik-1 formant les K entrées analogiques de l'étage,

.  un amplificateur à gain commandé AGC, présentant une entrée analogique reliée à la sortie analogique de l'étage de commutation 20, une entrée numérique recevant un mot numérique constitué des N bits de poids le plus faible C(0:N-1) d'un mot de commande C(0:M-1), et une sortie analogique constituant la sortie analogique du dispositif, amplificateur AGC dont le gain varie de 0 à G0 en fonction de la valeur du mot C(0:N-1) reçu sur son entrée numérique.

.  un décodeur 30 présentant une entrée numérique de (M-N) bits recevant un mot numérique constitué des (M-N) bits de poids le plus fort C(N:M-1) du mot de commande C(0:M-1), décodeur 30 présentant K sorties logiques S (0:K-1) reliées aux K entrées logiques de l'étage de commutation 20, sorties logiques S(0:K-1) dont une seule est placée dans un état actif, la position de ladite sortie logique étant fonction de la valeur du mot C(N:M-1) que le décodeur 30 a reçu sur son entrée numérique.

Dans ce mode de réalisation, la sortie de l'amplificateur Ai (pour i=0 à K-1)est reliée à l'interrupteur Ii, lui-même commandé par la sortie S(i) du décodeur.

La figure 2 est une caractéristique représentant l'évolution du gain en décibels G(dB), défini par la relation $G(dB)=20.\log(V_{out}/V_{in})$, d'un dispositif d'amplification suivant l'invention en fonction de la valeur numérique CODE du mot de commande C(0:M-1). La droite D représente une caractéristique nominale, c'est-à-dire un gain en décibels évoluant parfaitement linéairement en fonction de la valeur numérique CODE du mot de commande C(0:M-1). Les points représentent le gains Gi de chaque amplificateur Ai (pour i=0 à K-1) sont répartis sur la droite nominale D, ce qui illustre la linéarité de l'évolution du gain de l'étage d'amplification en fonction des (M-N) bits de poids le plus fort du mot de commande C(0:M-1). Les écarts périodiques constatés entre deux valeurs successives (Gi, Gi+1) par rapport à la droite nominale D, qui ont été volontairement exagérés sur cette figure, illustrent un défaut de linéarité du gain en décibels G(dB)de l'amplificateur à gain contrôlé AGC. Ils montrent en particulier que l'erreur produite par ce défaut de linéarité est indépendante du gain total du dispositif. Elle ne dépend que des propriétés intrinsèques de l'amplificateur à gain contrôlé AGC. L'erreur maximale peut-être calculée si l'on connait la caractéristique de transfert dudit amplificateur AGC. Si, par exemple, celle-ci est du type :

$$G = 1+C/2^{N+1},$$

(où $C=0,...,2^{N+1}$), et si G0=6dB l'erreur est donnée par:

$$ERR = [20.\text{Log}(1+C/2^{N+1})] - [6.C/2^{N+1})]$$

On a donc :

$$dERR/dC = [(20/\ln10).(1/2^{N+1}).(1/(1+C/2^{N+1}))] - 6/2^{N+1}$$

ou encore :

$$dERR/dC = (20.2^{N+1}-6.\ln10.2^{N+1}-6.\ln10.C)/(\text{dénominateur}),$$

la valeur du dénominateur n'étant pas importante pour le calcul de l'erreur maximale. On observe que l'erreur est maximale pour :

$$C = 2^{N+1}.[(20/(6.\ln10))-1] = 0,44.2^{N+1}$$

En substituant cette valeur dans l'équation donnant l'erreur ERR, on obtient l'erreur maximale :

$$ERRmax = 0,5dB$$

Dans un amplificateur où la valeur de G0 est, comme dans cet exemple, de 6dB, cette erreur est au pire inférieure à 10% du gain total du dispositif quand celui-ci est à sa valeur minimale G0 et devient rapidement négligeable à mesure que le gain total augmente.

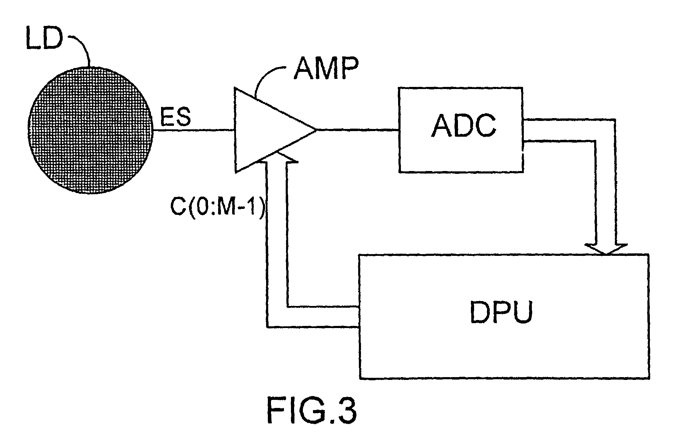

La figure 3 est un schéma fonctionnel décrivant partiellement une caméra comportant un amplificateur à gain contrôlé selon l'invention. Une telle caméra contient :

- un dispositif LD de détection de lumière et de conversion de la lumière en signaux électroniques analogiques ES,
- un dispositif d'amplification AMP tel que décrit plus haut, présentant une entrée de signal analogique recevant les dits signaux électroniques analogiques ES, une entrée numérique recevant un mot numérique C(0:M-1), dit mot de commande, servant à contrôler le gain du dispositif d'amplification AMP, et une sortie de signal analogique,
- un convertisseur analogique/numérique ADC présentant une entrée analogique reliée à la sortie du dispositif d'amplification AMP, et une sortie numérique, et
- une unité de traitement numérique DPU dont une entrée est reliée à la sortie du convertisseur analogique/numérique, unité émettant le mot de commande C(0:M-1) vers le dispositif d'amplification AMP.

## Revendications

1. Dispositif d'amplification à gain commandé (AMP), présentant une entrée analogique destinée à recevoir une tension (Vin) dite tension analogique d'entrée, une entrée numérique destinée à recevoir un mot de M bits C(0:M-1), dit mot de commande, servant à commander le gain du dispositif, et une sortie analogique destinée à délivrer une tension (Vout) dite tension analogique de sortie, **caractérisé en ce qu'**il comprend :

   - un étage dit d'amplification (10), présentant une entrée formant l'entrée analogique du dispositif et K sorties, contenant K amplificateurs (A0...Ak-1), chaque amplificateur présentant une entrée reliée à l'entrée de l'étage et une sortie formant l'une des K sorties de l'étage, les amplificateurs ayant des gains en décibels différents les uns des autres, le gain en décibels de chaque amplificateur étant un multiple d'une valeur appelée G0,
   - un étage dit de sélection (20) présentant K entrées logiques, muni de moyens pour activer une seule des K sorties de l'étage d'amplification (10) et pour désactiver les autres, en fonction des signaux reçus sur les K entrées logiques, matérialisés par les K bits de poids le plus fort du mot de commande,
   - un amplificateur à gain commandé (AGC), présentant une entrée analogique recevant celle des K sorties de l'étage d'amplification qui a été activée par l'étage de sélection, une entrée numérique recevant un mot numérique C(0:N-1) constitué des N bits de poids le plus faible du mot de commande C(0:M-1), et une sortie analogique constituant la sortie analogique du dispositif, amplificateur (AGC) dont le gain varie en fonction de la valeur du mot C(0:N-1) reçu sur son entrée numérique.

2. Dispositif d'amplification à gain commandé (AMP), présentant une entrée analogique destinée à recevoir une tension (Vin) dite tension analogique d'entrée, une entrée numérique destinée à recevoir un mot de M bits C(0:M-1), dit mot de commande, servant à commander le gain du dispositif, et une sortie analogique destinée à délivrer une tension (Vout) dite tension analogique de sortie, **caractérisé en ce qu'**il comprend :

   - un étage dit d'amplification (10), présentant une entrée formant l'entrée analogique du dispositif et K sorties, contenant K amplificateurs (A0...Ak-1), chaque amplificateur présentant une entrée reliée à l'entrée de l'étage et une sortie formant l'une des K sorties de l'étage, les amplificateurs ayant des gains en décibels différents les uns des autres, le gain en décibels de chaque amplificateur étant un multiple d'une valeur appelée G0,
   - un étage dit de commutation (20) présentant K entrées analogiques reliées aux K sorties de l'étage d'amplification (10), une sortie analogique et K entrées logiques, étage comprenant K interrupteurs (I0...Ik-1), commandés chacun par un signal S(0)...S(k-1) reçu sur une des K entrées logiques, les interrupteurs ayant tous une borne reliée en commun, formant ainsi la sortie analogique de l'étage, les autres bornes des interrupteurs formant les K entrées analogiques de l'étage,
   - un amplificateur à gain commandé (AGC), présentant une entrée analogique reliée à la sortie analogique de l'étage de commutation (20), une entrée numérique recevant un mot numérique C(0:N-1) constitué des N bits de poids le plus faible du mot de commande C(0:M-1), et une sortie analogique constituant la sortie analogique du dispositif, amplificateur (AGC) dont le gain varie en fonction de la valeur du mot reçu sur son entrée numérique,
   - un décodeur (30) présentant une entrée numérique de (M-N) bits recevant un mot numérique C(N:M-1) constitué des (M-N) bits de poids le plus fort du mot de commande C(0:M-1), décodeur présentant K sorties logiques reliées aux K entrées logiques de l'étage de commutation (20), sorties logiques dont une seule est placée dans un état actif, la position de ladite sortie logique étant fonction de la valeur du mot C(N:n-1) que le décodeur (30) a reçu sur son entrée numérique.

**3.** Dispositif d'amplification à gain contrôlé (AMP) selon l'une des revendications 1 ou 2, **caractérisé en ce que** les valeurs des gains en décibels des amplificateurs (A0...Ak-1) de l'étage d'amplification (10) sont des multiples successifs de G0, et **en ce que** le gain en décibels de l'amplificateur à gain commandé (AGC) varie de zéro à G0.

**4.** Dispositif d'amplification à gain contrôlé (AMP) selon l'une des revendications 1 à 3, **caractérisé en ce que**, considérant les amplificateurs (A0...Ak-1) de l'étage d'amplification (10) dans un ordre correspondant à celui des gains croissants, la sortie de l'amplificateur (A0) de gain le plus faible est reliée à celui des interrupteurs (I0) de l'étage de commutation (20) qui est commandé par la sortie logique commandée par le bit de poids le plus faible S(0) reçu sur l'entrée numérique du décodeur, les sorties successives des autres amplificateurs étant respectivement reliées à ceux des interrupteurs de l'étage de commutation qui sont commandés par ordre croissant en fonction de l'augmentation de la valeur du mot de commande.

**5.** Caméra contenant

- un dispositif (LD) de détection de lumière et de conversion de la lumière en signaux électroniques analogiques (ES).
- un dispositif d'amplification (AMP) présentant une entrée de signal analogique destiné à recevoir les dits signaux électroniques analogiques (ES), une entrée numérique destiné à recevoir un mot numérique C(0:M-1), dit mot de commande, pour contrôler le gain du dispositif d'amplification (AMP), et une sortie de signal analogique,
- un convertisseur analogique/numérique (ADC) présentant une entrée analogique reliée à la sortie du dispositif d'amplification (AMP), et une sortie numérique, et
- une unité de traitement numérique (DPU) dont une entrée est reliée à la sortie du convertisseur analogique/numérique (ADC), unité destinée à émettre le mot de commande C(0:M-1) vers le dispositif d'amplification,

   **caractérisée en ce que** ledit dispositif d'amplification (AMP) est conforme à l'une des revendications 1 à 4.

**Patentansprüche**

**1.** Verstärkeranordnung mit gesteuerter Verstärkung (AMP), mit einem analogen Eingang für den Erhalt einer sogenannten analogen Eingangsspannung (Vin), einem digitalen Eingang für den Erhalt eines Wortes mit M Bits C(O:M-1), dem sogenannten Steuerbit, das zur Steuerung der Verstärkung des Verstärkers dient, und einem analogen Ausgang zur Abgabe einer sogenannten analogen Ausgangsspannung, **dadurch gekennzeichnet, dass** sie enthält:

- eine sogenannte Verstärkerstufe (10) mit einem Eingang, der den analogen Eingang der Anordnung bildet, und K Ausgängen, mit K Verstärkern (AO...Ak-1) versehen, wobei jeder Verstärker einen Eingang aufweist, mit dem Eingang der Stufe verbunden, und einen Ausgang, der einen der K Ausgänge der Stufe bildet, die Verstärker voneinander verschiedene Dezibelverstärkungen haben und die Dezibelverstärkung jedes Verstärkers ein Vielfaches eines mit GO bezeichneten Wertes ist,
- eine sogenannte Auswahlstufe (20) mit K logischen Eingängen, versehen mit Verfahren zum Aktivieren eines einzigen der K Ausgänge der Verstärkerstufe (10), und um die anderen zu deaktivieren, entsprechend den an den K logischen Eingängen erhaltenen Signalen, in der Form der K Bits mit dem größten Stellenwert des Steuerwortes,
- einen Verstärker mit gesteuerter Verstärkung (AGC) mit einem analogen Eingang für den Erhalt dessen der K Ausgänge der Verstärkerstufe, der von der Auswahlstufe aktiviert wurde, wobei ein digitaler Eingang ein digitales Wort C(O:N-1) erhält, gebildet aus den N Bits mit dem geringsten Stellenwert des Steuerwortes, und mit einem analogen Ausgang, der den analogen Ausgang der Anordnung bildet, ein Verstärker (AGC), dessen Verstärkung je nach dem Wert des an seinem digitalen Eingang erhaltenen Wortes C(O:N-1) variiert.

**2.** Verstärkeranordnung mit gesteuerter Verstärkung (AMP), mit einem analogen Eingang für den Erhalt der besagten analogen Eingangsspannung (Vin), einem digitalen Eingang für den Erhalt eines Wortes mit M Bits C(O:M-1), dem sogenannten Steuerwort, das zur Steuerung der Verstärkeranordnung dient, und einem analogen Ausgang zur Abgabe einer Spannung (Vout), der sogenannten analogen Ausgangsspannung, **dadurch gekennzeichnet, dass** er enthält:

- eine sogenannte Verstärkerstufe (10) mit einem Eingang, der den analogen Eingang der Anordnung bildet, und K Ausgängen, mit K Verstärkern (AO...Ak-1), wobei jeder Verstärker einen Eingang aufweist, mit dem Eingang der Stufe verbunden, und einem Ausgang, der einen der K Ausgänge der Stufe bildet, die Verstärker voneinander verschiedene Dezibelverstärkungen haben und die Dezibelverstärkung jedes Verstärkers ein Vielfaches eines mit GO bezeichneten Wertes ist,
- eine sogenannte Umschaltstufe (20) mit K analogen Eingängen, mit den K Ausgängen der Verstärkerstufe (10) verbunden, einem analogen Ausgang und K logischen Eingängen, eine Stufe mit K Unterbrechern (IO... Ik-1), jeweils gesteuert von einem Signal S(O)...S(k-1), erhalten an einem der K logischen Eingänge, wobei die Unterbrecher alle eine gemeinsam verbundene Klemme haben und so den analogen Ausgang der Stufe bilden, und die anderen Klemmen der Unterbrecher die K analogen Eingänge der Stufe bilden,
- einen Verstärker mit gesteuerter Verstärkung ()AGC mit einem analogen Eingang, mit dem analogen Ausgang der Umschaltstufe (20) verbunden, einem digitalen Eingang für den Erhalt eines digitalen Wortes C(O:N-1), gebildet aus N Bits mit dem geringsten Stellenwert des Steuerwortes C(O:M-1), und einem analogen Ausgang zur Bildung des analogen Ausgangs der Anordnung, ein Verstärker (AGC), dessen Verstärkung je nach dem Wert des an seinem digitalen Eingang erhaltenen Wortes variiert,
- einen Dekodierer (30) mit einem digitalen Eingang mit (M-N) Bits für den Erhalt eines digitalen Wortes C(N:M-1), gebildet aus den (M-N) Bits mit dem größten Stellenwert des Steuerwortes C(O:M-1), wobei der Dekodierer K logische Ausgänge aufweist, mit den K logischen Eingängen der Umschaltstufe (20) verbunden, von seinen logischen Ausgängen nur einer in aktiven Zustand gebracht wird und die Position des besagten logischen Ausgangs vom Wert des Wortes C(N:M-1) abhängt, das der Dekodierer (30) an seinem digitalen Eingang erhält.

3. Verstärker mit gesteuerter Verstärkung (AMP) nach einem der Ansprüche 1 oder 2, **dadurch gekennzeichnet, dass** die Werte der Dezibelverstärkungen der Verstärker (AO...Ak-1) der Verstärkerstufe (10) aufeinanderfolgende Vielfache von GO sind, und dass die Dezibelverstärkung des Verstärkers mit gesteuerter Verstärkung (AGC) von null bis GO variiert.

4. Verstärkeranordnung mit gesteuerter Verstärkung (AMP) nach einem der Ansprüche 1 bis 3, **dadurch gekennzeichnet, dass** wenn die Verstärker (AO...Ak-1) der Verstärkerstufe (10) in der ihrer steigenden Verstärkungen betrachtet werden, der Ausgang des Verstärkers (AO) mit der geringsten Verstärkung mit dem der Unterbrecher (IO) der Umschaltstufe (20) verbunden ist, der vom logischen Ausgang gesteuert wird, gesteuert vom Bit mit dem geringsten Stellenwert S(O), erhalten am digitalen Eingang des Dekodierers, während die aufeinanderfolgenden Ausgänge der anderen Verstärker respektive mit denen der Unterbrecher der Umschaltstufe verbunden sind, die in aufsteigender Reihenfolge entsprechend dem ansteigenden Wert des Steuerwortes gesteuert werden.

5. Kamera mit:

- einer Vorrichtung (LD) zur Erkennung von Licht und zur Umwandlung des Lichtes in analoge elektronische Signale (ES),
- einer Verstärkeranordnung (AMP) mit einem analogen Signaleingang für den Erhalt der besagten analogen elektronischen Signale (ES), einem digitalen Eingang für den Erhalt eines digitalen Wortes C(O:M-1), dem sogenannten Steuerwort, um die Verstärkung der Verstärkeranordnung (AMP) zu steuern, und einem analogen Signalausgang,
- einem Analog-Digital-Wandlungsgerät (ADC) mit einem analogen Eingang, mit dem Ausgang der Verstärkeranordnung (AMP) verbunden, und einem digitalen Ausgang, und
- einer digitalen Verarbeitungseinheit DPU, von der ein Eingang mit dem Ausgang des Analog-Digital-Wandlungsgeräts (ADC) verbunden ist, dazu bestimmte Einheit, um das Steuerwort zur Verstärkeranordnung zu übertragen,

**dadurch gekennzeichnet, dass** die Verstärkeranordnung (AMP) eineM der Ansprüche 1 bis 4 entspricht.

**Claims**

1. A gain-controlled amplifying device (AMP) having an analog input for receiving an analog input voltage (Vin), a digital input for receiving a word of M bits C(O:M-1), referred to as control word, for controlling the gain of the device, and an analog output for supplying an analog output voltage (Vout), **characterized in that** it comprises:

an amplifying stage (10) having an input constituting the analog input of the device, and K outputs, comprising K amplifiers (A0...Ak-1), each amplifier having an input connected to the input of the stage and an output constituting one of the K outputs of the stage, the amplifiers having mutually different decibel gains, the decibel gain of each amplifier being a multiple of a value referred to as G0,

a selection stage (20) having K logic inputs, provided with means for activating one of the K outputs of the amplifying stage and for deactivating the other outputs as a function of the signals received at the K logic inputs, materialized by the K most significant bits of the control word,

a gain-controlled amplifier (AGC) having an analog input receiving that of the K outputs of the amplifying stage which is activated by the selection stage, a digital input receiving a digital word C(O:N-1) constituted by the N least significant bits of the control word C(O:M-1), and an analog output constituting the analog output of the device, the gain of said amplifier (AGC) varying as a function of the value of the word C(O:N-1) received at its digital input.

2. A gain-controlled amplifying device (AMP) having an analog input for receiving an analog input voltage (Vin), a digital input for receiving a word of M bits C(O:M-1), referred to as control word, for controlling the gain of the device, and an analog output for supplying an analog output voltage (Vout), **characterized in that** it comprises:

an amplifying stage (10) having an input constituting the analog input of the device, and K outputs, and comprising K amplifiers (A0...Ak-1), each amplifier having an input connected to the input of the stage and an output constituting one of the K outputs of the stage, the amplifiers having mutually different decibel gains, the decibel gain of each amplifier being a multiple of a value referred to as G0, the stage, the amplifiers having mutually different decibel gains, the decibel gain of each amplifier being a multiple of a value referred to as G0,

a switching stage (20) having K analog inputs connected to K outputs of the amplifying stage (10), an analog output and K logic inputs, said stage comprising K switches (I0...Ik-1) each controlled by a signal S(0)...S(k-1) received at one of the K logic inputs, all switches having a terminal connected in common, thus constituting the analog output of the stage, the other terminals of the switches constituting the K analog inputs of the stage,

a gain-controlled amplifier (AGC) having an analog input connected to the analog output of the switching stage (20), a digital input receiving a digital word C(O:N-1) constituted by the N least significant bits of the control word C(O:M-1), and an analog output constituting the analog output of the device, said amplifier (AGC) having a gain which varies as a function of the value of the word received at its digital input,

a decoder (30) having a digital input of (M-N) bits receiving a digital word C(N:M-1) constituted by the (M-N) most significant bits of the control word C(O:M-1), said decoder having K logic outputs connected to the K logic inputs of the switching stage (20), one of said logic outputs being put in an active state, the position of said logic output being a function of the value of the word C(N:M-1) received at the digital input of the decoder (30).

3. A gain-controlled amplifying device (AMP) as claimed in claim 1 or 2, **characterized in that** the values of the decibel gains of the amplifiers (A0...Ak-1) of the amplifying stage (10) are successive multiples of G0, and **in that** the decibel gain of the gain-controlled amplifier (AGC) varies between zero and G0.

4. A gain-controlled amplifying device (AMP) as claimed in any one of claims 1 to 3, **characterized in that**, in considering the amplifiers (A0...Ak-1) of the amplifying stage (10) in an order corresponding to that of increasing gains, the output of the amplifier (A0) having the smallest gain is connected to that of the switches (IO) of the switching stage (20) which is controlled by the logic output controlled by the least significant bits S(O) received at the digital input of the decoder, the successive outputs of the other amplifiers being connected, respectively, to those outputs of the switches of the switching stage which are controlled in an ascending order as a function of the increase of the value of the control word.

5. A camera comprising:

a device (LD) for detecting light and converting the light into analog electronic signals (ES),

an amplifying device (AMP) having an analog signal input intended to receive said analog electronic signals (ES), a digital input intended to receive a digital word C(O:M-1), referred to as control word, for controlling the gain of the amplifying device (AMP), and an analog signal output,

an A/D converter (ADC) having an analog input connected to the output of the amplifying device (AMP), and a digital output, and

a digital processing unit (DPU) having an input connected to the output of the A/D converter (ADC), which unit is intended to apply the control word C(O:M-1) to the amplifying device,

**characterized in that** said amplifying device (AMP) is a device as claimed in any one of claims 1 to 4.

FIG.1

FIG.2

AMP

G(dB)

EP 0 813 297 B1

FIG.3

EP 0 813 297 B1